# FASCICULE DE BREVET EUROPEEN

(11) **EP 1 692 527 B1**
(45) Date de publication et mention de la délivrance du brevet: **04.04.2007**
(21) Numéro de dépôt: 04805528.9
(22) Date de dépôt: 24.11.2004
(51) Int. Cl.: G01R 15/20

(54) **CAPTEUR DE COURANT A SENSIBILITE REDUITE AUX CHAMPS MAGNETIQUES PARASITES**
STROMSENSOR MIT VERRINGERTER EMPFINDLICHKEIT GEGENÜBER MAGNETISCHEN STREUFELDERN
CURRENT SENSOR WITH REDUCED SENSITIVITY TO STRAY MAGNETIC FIELDS

(30) Priorité: 08.12.2003 FR 0314331
(43) Date de publication de la demande: 23.08.2006
(73) Titulaire: ABB Entrelec, 69100 Villeurbanne (FR)
(72) Inventeur: NOEL, Sebastien, F-69230 ST GENIS LAVAL (FR)
(74) Mandataire: Laget, Jean-Loup
(86) Numéro de dépôt international: PCT/FR2004/002999
(87) Numéro de publication internationale: WO 2005/066642

(56) Documents cités:
- EP-A- 1 030 183
- WO-A-02/46777
- US-A- 4 625 166
- DATABASE WPI Section EI, Week 197946 Derwent Publications Ltd., London, GB; Class S01, AN 1979-K7728B XP002291323 -& SU 649 045 A (DOLGIKH V V) 25 février 1979 (1979-02-25)

## Description

La présente invention concerne un capteur de courant destiné à mesurer la valeur du courant s'écoulant dans un conducteur.

La présente invention concerne plus particulièrement un capteur de courant, du type sans noyau magnétique, comprenant un support apte à être positionné autour du conducteur parcouru par le courant à mesurer, plusieurs composants sensibles au champ magnétique disposés sur ledit support de façon à être répartis autour dudit conducteur, et un circuit de traitement recevant un signal de sortie desdits composants sensibles au champ magnétique. Chaque composant sensible au champ magnétique comporte au moins une première et une seconde bornes. Les premières bornes de tous les composants sensibles au champ magnétique sont reliées par des résistances respectives de sommation à un point de sommation raccordé à une première borne d'entrée du circuit de traitement. Les seconde bornes de tous les composants sensibles au champ magnétique sont reliées à une seconde borne d'entrée du circuit de traitement. Les composants sensibles au champ magnétique peuvent être par exemple des sondes à effet Hall, des magnétorésistances ou d'autres éléments aptes à produire un signal électrique quand ils sont placés dans un champ magnétique. Des capteurs de ce type sont connus par exemple par les documents EP 1 030 183 A1 et US-A-4 625 166.

Les capteurs de courant sans noyau magnétique présentent de nombreux avantages par rapport aux capteurs de courant avec noyau magnétique. C'est ainsi que les capteurs de courant sans noyau magnétique sont beaucoup plus légers que les capteurs de courant avec noyau magnétique, précisément à cause de l'absence de noyau magnétique. En outre, ils ont une plus grande plage d'utilisation tant du point de vue de la fréquence maximale que du point de vue de la valeur maximale de l'intensité du courant qu'ils peuvent mesurer, du fait de l'absence de saturation d'un noyau magnétique. En outre, les capteurs de courant sans noyau magnétique offrent l'avantage de ne pas être sujet à échauffement, de sorte qu'ils peuvent être plus compacts. De plus, ces capteurs de courant sont capables de mesurer, sans être détruits, des surintensités momentanées dans le conducteur parcouru par le courant à mesurer. Ceci est dû au fait que les composants sensibles au champ magnétique sont capables de mesurer des champs magnétiques importants engendrés par le courant d'intensité importante circulant dans le conducteur, et que le circuit électronique de traitement placé en sortie des composants peut saturer sans se détériorer.

Toutefois, les capteurs de courant sans noyau magnétique présentent l'inconvénient d'être sensibles à des champs magnétiques parasites ou non homogènes, et aux variations de champ magnétique.

La présente invention a donc pour but de fournir un capteur de courant du genre défini en préambule qui soit moins sensible à des champs magnétiques parasites ou non homogènes, et à des variations de champ magnétique.

A cet effet, l'invention a pour objet un capteur de courant destiné à mesurer la valeur du courant s'écoulant dans un conducteur, comprenant un support apte à être positionné autour du conducteur parcouru par le courant à mesurer, plusieurs composants sensibles au champ magnétique, disposés sur ledit support de façon à être répartis autour dudit conducteur, et un circuit de traitement recevant un signal de sortie desdits composants sensibles au champ magnétique, chaque composant sensible au champ magnétique comportant au moins une première et une seconde bornes, les premières bornes de tous les composants sensibles au champ magnétique étant reliées par des résistances respectives de sommation à un point de sommation raccordé à une première borne d'entrée du circuit de traitement, les secondes bornes de tous les composants sensibles au champ magnétique étant reliées à une seconde borne d'entrée du circuit de traitement, caractérisé en ce que toutes les résistances de sommation sont connectées à un premier conducteur relié au point de sommation, toutes les secondes bornes des composants sensibles au champ magnétique sont connectées à un second conducteur relié à la seconde borne d'entrée du circuit de traitement, le support est constitué par un circuit imprimé, et les premier et second conducteurs sont constitués respectivement par des première et seconde pistes conductrices du circuit imprimé qui sont routées en zigzag sur le circuit imprimé de manière à former une torsade ou une tresse.

Le capteur de courant selon l'invention peut en outre présenter une ou plusieurs des caractéristiques suivantes :
- le circuit imprimé a deux faces imprimées et les pistes conductrices sont routées sur les deux faces du circuit imprimé,
- chacune des première et seconde pistes conductrices forme une boucle fermée tout autour d'une ouverture prévue dans le circuit imprimé pour le passage du conducteur parcouru par le courant à mesurer ;
- chaque résistance de sommation a ses deux bornes qui sont connectées respectivement au plus près de la première borne du composant correspondant sensible au champ magnétique et au plus près de la première piste conductrice ;
- le circuit imprimé comporte sur au moins une de ses deux faces un plan de masse entourant étroitement les pistes conductrices du circuit imprimé ;
- le plan de masse forme une boucle fermée tout autour de ladite ouverture ;
- la seconde piste conductrice est reliée au plan de masse en un point de celui-ci qui est adjacent à la première piste conductrice, et ledit point de sommation auquel est reliée la première piste conductrice est adjacent audit point du plan de masse auquel est reliée la seconde piste conductrice ;
- les composants sensibles au champ magnétique sont des sondes à effet Hall ;
- chaque sonde à effet Hall comprend des troisième et quatrième bornes, les troisièmes bornes de toutes les sondes à effet Hall étant connectées à une troisième piste conductrice du circuit imprimé, qui est reliée à un point à un premier potentiel fixe et qui est routée en zigzag sur ledit circuit imprimé de manière à former une torsade ou une tresse avec les première et seconde pistes conductrices ;
- la troisième piste conductrice forme une boucle fermée tout autour de ladite ouverture ;
- les seconde et quatrième bornes des sondes à effet Hall sont connectées ensemble à la seconde piste conductrice du circuit imprimé, elle-même reliée à un second potentiel fixe ou potentiel de masse ;
- ledit point au premier potentiel fixe auquel est reliée la troisième piste conductrice est situé sur le circuit imprimé à côté dudit point de sommation et dudit point de connexion au plan de masse.

L'invention sera mieux comprise grâce à la description qui va suivre donnée à titre d'exemple non limitatif en référence aux dessins annexés dans lesquels :
- la figure 1 est une vue en perspective montrant un capteur de courant selon l'invention, placé autour d'un jeu de barres conductrices parcourues par un courant à mesurer ;
- la figure 2 est un schéma électrique simplifié du capteur de courant de la figure 1 ;
- la figure 3 est une vue en perspective montrant une portion d'un circuit imprimé portant une piste conductrice routée en zigzag ;
- la figure 4 est un schéma de principe permettant d'expliquer pourquoi le capteur de courant de l'invention est moins sensible aux champs magnétiques parasites ;
- la figure 5 est une vue de la face avant du circuit imprimé d'un capteur de courant selon l'invention ;
- la figure 6 est une vue de la face arrière du circuit imprimé du capteur de courant ;
- la figure 7 est une vue montrant simultanément les pistes conductrices des faces avant et arrière du circuit imprimé des figures 5 et 6, le substrat du circuit imprimé étant supposé transparent et dépourvu de plan de masse.
- la figure 8 montre, à plus grande échelle, une partie du circuit imprimé de la figure 7, dans la région d'implantation de l'un des composants sensibles au champ magnétique.

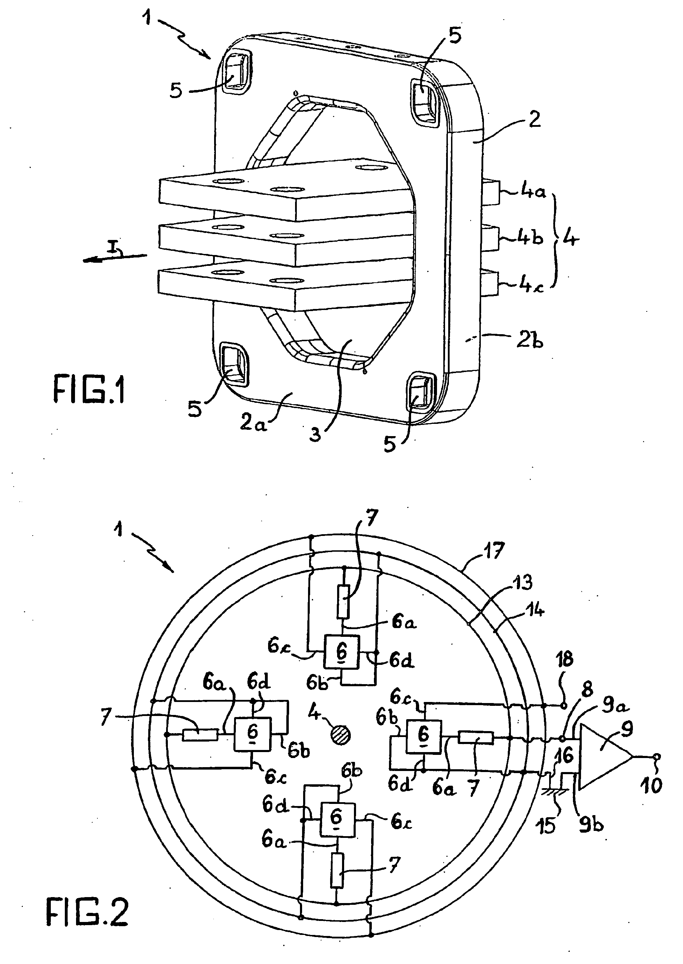

En se rapportant tout d'abord à la figure 1, on peut voir un capteur de courant 1 selon l'invention, qui comporte un boîtier 2 en une matière isolante, qui contient des éléments actifs et/ou fonctionnels du capteur de courant (non montrés dans la figure 1).

Le boîtier 2 a une forme générale parallélépipédique, avec deux faces principales opposées 2a et 2b, de forme générale carrée ou rectangulaire avec des angles arrondis. Le boîtier 2 comporte une large ouverture centrale 3 qui le traverse de part en part, de la face 2a à la face 2b, et grâce à laquelle le capteur de courant 1 peut être placé autour d'un conducteur électrique 4 parcouru par un courant 1 à mesurer. Dans la figure 1, le conducteur 4 est constitué par un jeu de barres conductrices, par exemple trois barres 4a, 4b et 4c. Bien entendu, le nombre des barres conductrices peut être plus petit que trois ou plus grand que trois, tout en restant des les limites permises par les dimensions de l'ouverture 3 du boîtier 2. En outre, le jeu de barres conductrices 4 pourrait être remplacé par un ou plusieurs câbles électriques parcourus par un courant à mesurer.

Comme montré dans la figure 1, le boîtier 2 comporte quatre trous 5 qui traversent le boîtier 2 de part en part, de la face 2a à la face 2b, pour recevoir des vis de fixation (non montrées) permettant la fixation du capteur de courant 1 debout ou couché sur un support approprié, soit directement, soit indirectement par l'intermédiaire d'éléments de montage, comme cela est bien connu (voir par exemple le document FR-A-2 793-884).

En se rapportant maintenant au schéma électrique de la figure 2, on peut voir que le capteur de courant 1 comporte plusieurs composants 6 sensibles au champ magnétique, dont les signaux de sortie sont envoyés respectivement à travers des résistances de sommation 7 à un point de sommation 8 lui-même relié électriquement à une première entrée 9a d'un circuit de traitement 9 dont la sortie 10 peut constituer la sortie du capteur de courant 1.

Les composants 6 sensibles au champ magnétique peuvent être par exemple constitué par des sondes à effet Hall. Les sondes 6 sont portées par un support (non montré dans la figure 2) de façon à être réparties autour du conducteur 4 parcouru par le courant à mesurer.

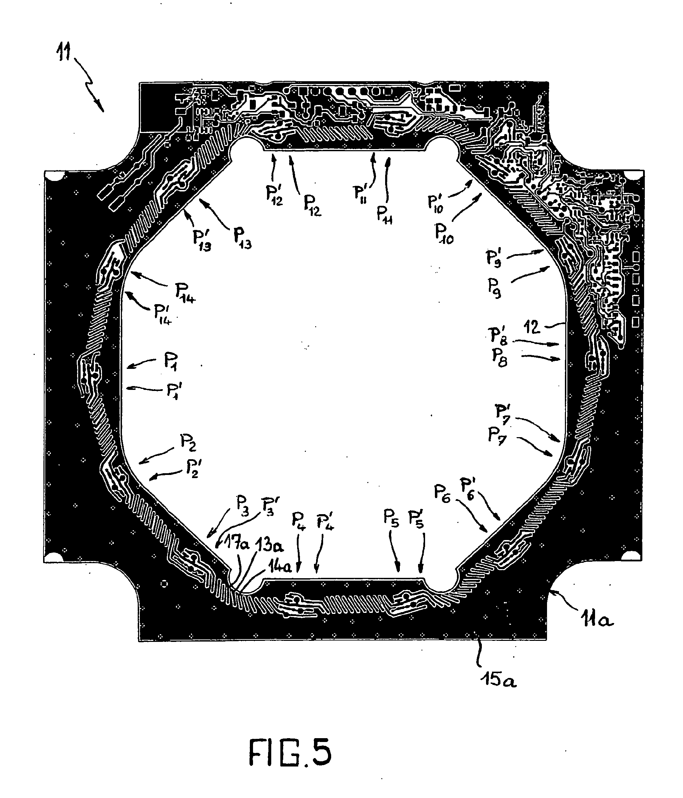

Le support susmentionné est constitué par un circuit imprimé 11, dont un exemple concret de réalisation est représenté sur les figures 5 à 8 et sera décrit en détail plus loin. Pour l'instant, il suffit de noter que le circuit imprimé 11 comporte en son milieu une ouverture 12 dont la forme et la dimension correspondent à celles de l'ouverture 3 du boîtier 2.

Dans le schéma de la figure 2, on a représenté seulement quatre sondes 6 pour des raisons de clarté de cette figure, mais il va de soi que l'invention n'est pas limitée à un capteur comportant quatre sondes 6 ou quatre composants sensibles au champ magnétique. Par exemple, le capteur 1 pourra comprendre quatorze sondes à effet Hall comme indiqué dans les figures 5 à 7 dans lesquelles les sondes ne sont pas représentées, mais leurs positions sur le circuit imprimé 11 sont indiquées respectivement par les références P₁ à P₁₄.

Comme montré dans la figure 2, chaque sonde 6 comporte quatre bornes 6a à 6d. Toutes les bornes 6a, qui délivrent les signaux de sortie utiles des sondes 6, sont reliées à travers les résistances 7 à un premier conducteur 13 qui est lui même relié au point de sommation 8 susmentionné. Les deux bornes 6b et 6d de chaque sonde 6 sont reliées ensemble l'une à l'autre et à un deuxième conducteur 14 qui est commun à toutes les sondes 6 et qui est lui même relié à la masse 15 de préférence en un seul point comme indiqué en 16 dans la figure 2. L'autre borne 9b du circuit de traitement 9, qui peut être constitué par un amplificateur opérationnel, est aussi reliée à la masse 15 comme montré dans la figure 2. Enfin, toutes les bornes 6c des sondes 6 sont reliées à un troisième conducteur 17 qui est lui même relié à un point 18. Le point 18 est à un premier potentiel fixe de par exemple +5V, tandis que la masse 15 est à un second potentiel fixe qui sert de potentiel de référence pour la mesure du courant.

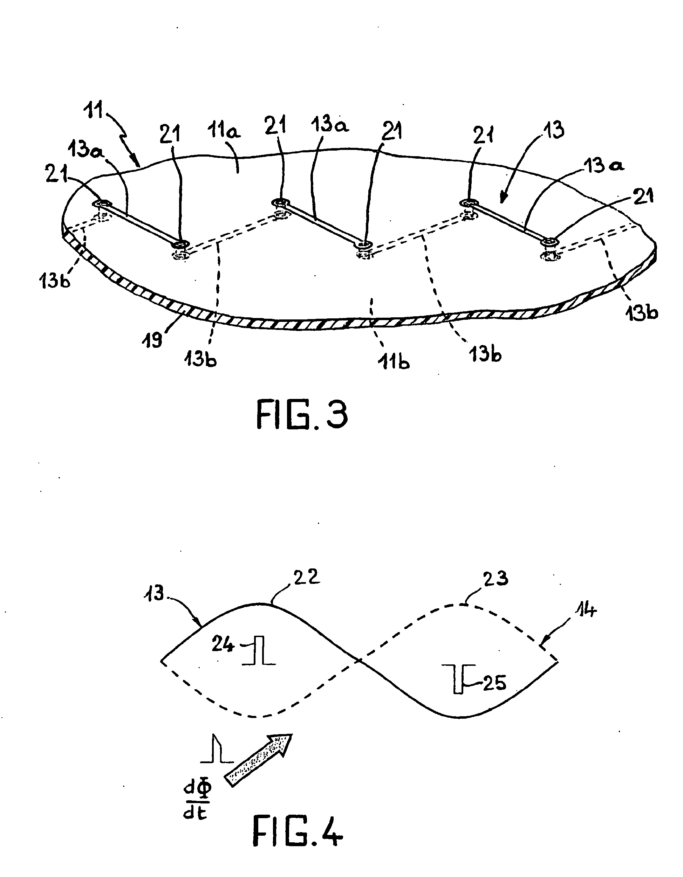

Afin de rendre le capteur de courant 1 moins sensible aux champs magnétiques parasites et aux variations de champ magnétique, les trois conducteurs 13, 14 et 17 sont torsadés ou tressés ensemble comme cela va maintenant être expliqué en référence aux figures 3 et 5 à 8.

Le circuit imprimé 11 comporte un substrat 19 (figures 3, 7 et 8) constitué par un matériau en plaque ou en feuille, en une matière plastique isolante, éventuellement renforcée par des fibres, comme par exemple des fibres de verre. Sur les deux faces du substrat 19 sont formées des pistes conductrices, par exemple en cuivre, par des techniques connues de photogravure.

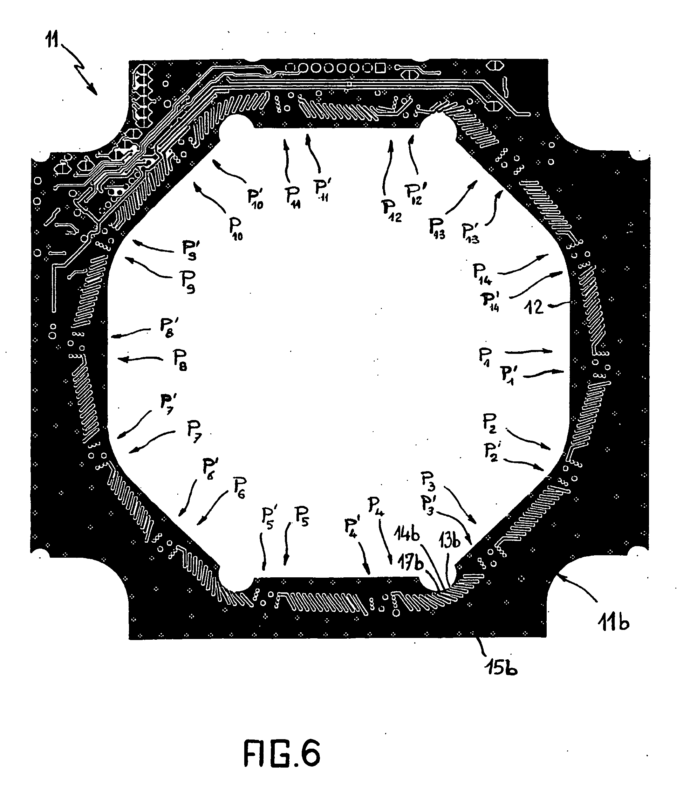

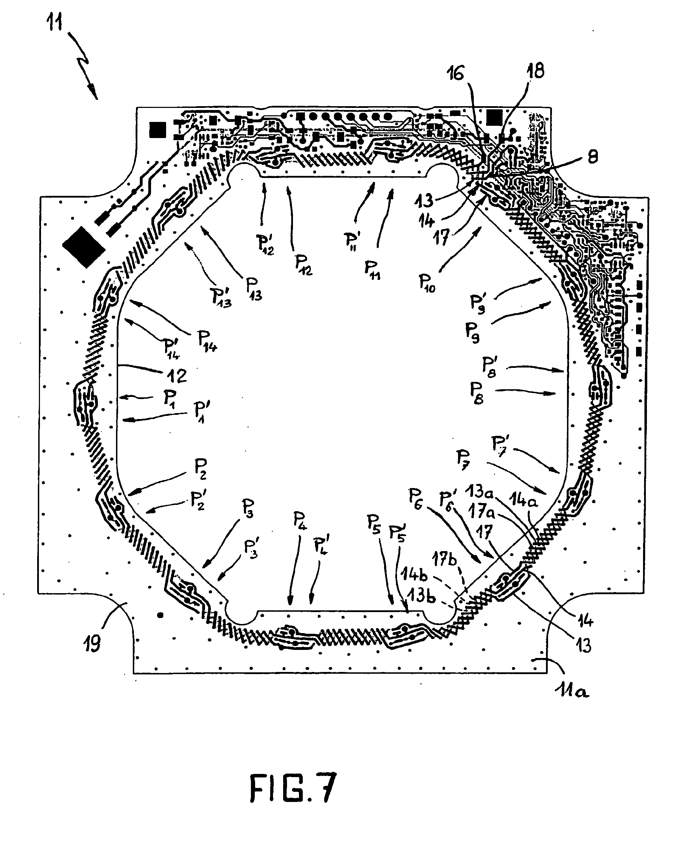

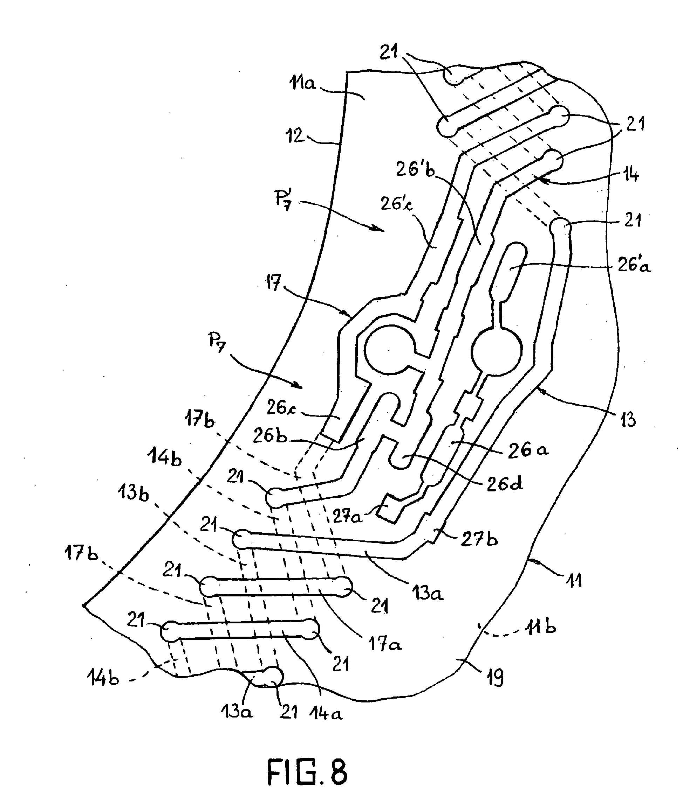

En particulier, chacun des trois conducteurs 13, 14 et 17 susmentionné est constitué par une piste conductrice, qui est désignée par le même numéro de référence 13, 14 ou 17 dans les figures 7 et 8 et qui est routée en zigzag comme cela est illustré dans la figure 3 à propos de la piste conductrice 13. Dans la figure 3, qui représente, à plus grande échelle, une petite partie du circuit imprimé 11, on a seulement représenté la piste conductrice 13 pour plus de clarté du dessin. Comme montré, dans les régions du circuit imprimé 11 situées entre les emplacements des sondes 6 à effet Hall, la piste 13 est constituée par une succession de segments conducteurs désignés alternativement par 13a et 13b. Les segments 13a, par exemple les segments d'ordre impair, sont situés sur la face avant 11a du circuit imprimé 11 (figures 3 et 5), tandis que les segments 13b, par exemple les segments d'ordre pair, sont situés sur la face arrière 11b du circuit imprimé 11 (figures 3 et 6). Les segments 13a sont reliés en série avec les segments 13b par des traversées conductrices 21.

De manière similaire, les pistes conductrices 14 et 17 sont formées par des segments 14a et 17a situées sur la face avant 11a du circuit imprimé 11 (figure 5) et par des segments 14b et 17b qui sont situés sur la face arrière 11b du circuit imprimé 11 (figure 6) et qui sont reliés en série respectivement avec les segments 14a et 17a par des traversées conductrices semblables aux traversées conductrices 21 comme on peut le voir dans la figure 8.

De préférence, chaque segment 14a de la piste conductrice 14, qui est reliée à la masse 15, est situé entre un segment 13a de la piste conductrice 13 et un segment 17a de la piste conductrice 17 comme cela est nettement visible dans les figures 5 et 8. De même, chaque segment 14b de la piste conductrice 14 est située entre un segment 13b de la piste conductrice 13 et un segment 17b de la piste conductrice 17 comme cela est visible dans les figures 6 et 8.

Dans la figure 7, les segments 13a, 14a et 17a des pistes conductrices 13, 14 et 17 sont représentés en traits gras noirs, tandis que les segments 13b, 14b et 17b des pistes conductrices 13, 14 et 17 sont représentés en traits gris, comme s'ils étaient vus en transparence à travers le substrat 19 du circuit imprimé 11.

On obtient de la sorte pour les trois pistes conductrices 13, 14 et 17 une structure torsadée qui permet de rendre le capteur de courant 1 moins sensible, voire insensible aux variations de champ magnétique parasite. En effet, le routage en zigzag des pistes conductrices torsadées peut être modélisé comme montré dans la figure 4 à propos des pistes conductrices 13 et 14 (une modélisation semblable pourrait être réalisée avec les pistes 14 et 17). Lorsque le capteur de courant est placé dans un environnement magnétique « sévère », c'est-à-dire non homogène, par exemple lorsque la ou les barre(s) conductrice(s) du jeu de barres 4 forment un angle ou un coude et que le capteur 1 est placé près dudit angle, ou encore lorsque le capteur 1 est placé près d'un conducteur parasite adjacent au jeu de barres 4 parcouru par le courant à mesurer, les variations de flux magnétique créé par le conducteur parasite ou les lignes de flux non homogènes traversant le capteur 1 induisent des tensions électriques dans les liaisons conductrices reliant les sondes 6 à effet Hall. Ces tensions viennent perturber les signaux délivrés par les sondes 6 à effet Hall et le capteur délivre alors une information erronée.

Cependant, comme montré sur la figure 4, grâce à la structure torsadée des pistes conductrices 13, 14 et 17, les variations dΦ/dt du flux magnétique arrosant deux boucles ou spires successives 22 et 23 de la torsade vont induire une tension positive 24 dans la première spire 22 et une tension négative 25 dans la seconde spire 23, puisque cette dernière voit le flux en sens inverse par rapport à la première spire. Si les deux spires 22 et 23 ont la même surface, les tensions 24 et 25 ont la même valeur absolue, mais des signes opposés de sortes qu'elles s'annulent. On voit donc que, en prévoyant un nombre paire de spires dans les torsades formées par les pistes conductrices 13 et 14 et par les conductrices 14 et 17, il est possible de faire en sorte que les tensions électriques parasites induites par les variations de champ magnétique parasite ou non homogène dans les liaisons électriques reliant les sondes 6 à effet Hall peuvent être annulés. On obtiendrait le même résultat si les pistes conductrices 13, 14 et 17 étaient routées en zigzag de manière à former une structure tressée, mais le dessin serait un peu plus complexe et nécessiterait un plus grand nombre de traversées conductrices 21.

Dans le cas où l'ouverture 3 du boîtier 2 du capteur 1 a un contour fermé et, par suite, aussi l'ouverture 12 du circuit imprimé 11, chacune des trois pistes conductrices 13, 14 et 17 forme de préférence une boucle fermée, qui est donc en court circuit, comme cela est visible dans les figures 2 et 5 à 7. Si les boucles formées par les pistes conductrices 13, 14 et 17 étaient ouvertes, les variations de flux magnétique engendreraient une force électromotrice entre les extrémités de la boucle ouverte formée par chaque piste conductrice 13, 14 ou 17. Ceci provoquerait une erreur de mesure, puisque les sondes 6 sont réparties le long des pistes conductrices.

De préférence, le circuit imprimé 11 comporte sur chacune de ses deux faces 11a et 11b, un plan de masse 15a ou 15b, respectivement, par exemple en cuivre, qui entoure étroitement les pistes conductrices du circuit imprimé. Les deux plans de masse 15a et 15b sont représentés par les larges plages noires dans les figures 5 et 6, et ils sont désignés globalement par la référence 15 dans la figure 2. Les deux plans de masse 15a et 15b sont interconnectés électriquement par au moins une traversée conductrice (non montrée) qui est placée dans le substrat 19 du circuit imprimé 11 d'une manière semblable aux traversées conductrices 21 montrées dans la figure 3.

De préférence, au moins un des deux plans de masse 15a et 15b, de préférence les deux plans de masse forment une boucle fermée, pour des raisons semblables à celles qui ont été indiquées plus haut à propos des pistes conductrices 13, 14 et 17. De cette manière, il est possible de s'affranchir des tensions parasites induites dans le plan de masse.

De préférence, la piste conductrice 14 est reliée au plan de masse 15 en un seul point 16 (figure 7) de celui-ci, qui est adjacent à la piste conductrice 13, et le point de sommation 8 auquel est reliée la piste conductrice 13 est adjacent au point 16 susmentionné. De même, le point 18 qui est au premier potentiel fixe (+5V) et auquel est reliée la piste conductrice 17, est situé sur le circuit imprimé 11 à côté du point de sommation 8 et du point 16 de connexion au plan de masse 15. Ces dispositions ont pour effet d'éviter que d'éventuelles tensions induites localement dans les pistes conductrices et/ou dans le plan de masse du circuit imprimé 11 ne viennent s'ajouter aux signaux fournis par les sondes 6 à effet Hall et ne viennent par conséquent perturber la mesure du courant.

Enfin, chaque résistance de sommation 7 a ses deux bornes qui sont connectées respectivement au plus près de la borne 6a de la sonde 6 à effet Hall correspondante et au plus près de la piste conductrice 13. Ceci apparaît nettement dans la figure 8 qui montre, à échelle agrandie, une partie du circuit imprimé 11 correspondant à l'une des sondes à effet Hall, plus précisément celle qui se trouve dans la position P₇. Dans la figure 8, les plages conductrices 26a à 26d du circuit imprimé 11 sont les plages auxquelles sont respectivement soudées les bornes 6a à 6d de la sonde 6 à effet Hall situé dans la position P₇, tandis que les plages conductrices 27a et 27b du circuit imprimé 11 sont les plages auxquelles sont soudées les deux bornes de la résistance de sommation 7 correspondante. Comme cela ressort également de la figure 8, les bornes 6b à 6d de la sonde 6 à effet Hall sont connectées au plus près des pistes conductrices 14 et 17 puisque les plages conductrices 26b et 26d servant à la connexion des bornes 6b et 6d se trouvent sur la piste 14 et que la plage conductrice 26c servant à la connexion de la borne 6c se trouve sur la piste 17.

Il existe des sondes à effet Hall dont le boîtier ne comporte que trois bornes ou pattes de connexion. Le circuit imprimé 11 peut avantageusement comporter en outre, en des emplacement P'₁ à P'₁₄ adjacents respectivement aux emplacements P₁ à P₁₄, des plages conductrices 26'a, 26'b et 26'c (figure 8) auxquelles peuvent être sondées les bornes des sondes à trois bornes.

Il va de soi que le mode de réalisation de l'invention qui a été décrit ci-dessus a été donné à titre d'exemple purement indicatif et nullement limitatif, et que de nombreuses modifications peuvent être facilement apportées par l'homme de l'art sans pour autant sortir du cadre de l'invention. C'est ainsi que, bien que l'invention ait été décrite à propos d'un capteur comportant des sondes à effet Hall, celles-ci pourraient être remplacées par d'autres éléments sensibles au champ magnétique, comme par exemple des magnétorésistances.

En outre, bien qu'il soit avantageux que les pistes conductrices 13, 14 et 17 et le plan de masse 15 forment des boucles fermées (en court circuit) tout autour de l'ouverture 12 du circuit imprimé 11 (cas d'un capteur de courant 11 dont le boîtier 2 a une ouverture 3 présentant un contour fermé), on ne sortirait pas du cadre de l'invention si les pistes conductrices 13, 14 et 17 et le plan de masse 15 ne formaient pas une boucle fermée, comme cela pourrait être le cas lorsque le boîtier du capteur de courant comporte une ouverture à contour non fermé pour que le capteur puisse être aisément placé à cheval sur le conducteur 4 par un déplacement transversal par rapport à la direction longitudinale dudit conducteur, sans que celui-ci ait besoin d'être déconnecté.

On pourrait également envisager de réaliser le capteur de courant en deux parties pouvant être séparées l'une de l'autre pour permettre la mise en place du capteur autour d'un conducteur parcouru par un courant à mesurer, des moyens étant alors prévus pour permettre une liaison mécanique des deux parties du capteur de courant, et d'autres moyens pour permettre des liaisons électriques appropriées entre les deux parties du capteur de courant quand elles sont assemblées l'une à l'autre, afin d'établir des boucles fermées pour les pistes conductrices 13, 14 et 17 reliant les composants 6 sensibles au champ magnétique.

En outre, bien que la structure en forme de torsade des conducteurs ou des pistes conductrices 13, 14 et 17 décrites plus haut soit obtenue en utilisant un circuit imprimé 11 ayant deux faces imprimées 11a et 11b, le routage en zigzag desdites pistes conductrices et la structure en forme de torsade ou de tresse pourraient être obtenus en utilisant un circuit imprimé sur une seule face. Dans ce cas, chaque piste conductrice 13, 14 ou 17 sera formée en partie (un segment conducteur sur deux) par des cavaliers (encore appelés « straps » par les hommes de l'art) chevauchant des segments conducteurs des autres pistes conductrices.

Selon une autre variante de réalisation, le routage en zigzag des pistes conductrices et la structure en forme de torsade ou tresse pourraient encore être obtenus en utilisant un circuit imprimé multicouche comportant des pistes conductrices sur au moins une face extérieure d'un substrat multicouche et sur au moins une couche intermédiaire dudit substrat.

## Revendications

1. Capteur de courant destiné à mesurer la valeur du courant s'écoulant dans un conducteur (4), comprenant un support (11) apte à être positionné autour du conducteur parcouru par le courant à mesurer, plusieurs composants (6) sensibles au champ magnétique, disposés sur ledit support (11) de façon à être répartis autour dudit conducteur (4), et un circuit de traitement (9) recevant un signal de sortie desdits composants (6) sensibles au champ magnétique, chaque composant sensible au champ magnétique comportant au moins une première et une seconde bornes, les premières bornes (6a) de tous les composants (6) sensibles au champ magnétique étant reliées par des résistances respectives de sommation (7) à un point de sommation (8) raccordé à une première borne d'entrée (9a) du circuit de traitement (9), les secondes bornes (6b) de tous les composants (6) sensibles au champ magnétique étant reliées à une seconde borne d'entrée (9b) du circuit de traitement, **caractérisé en ce que** toutes les résistances de sommation (7) sont connectées à un premier conducteur (13) relié au point de sommation (8), toutes les secondes bornes (6b) des composants (6) sensibles au champ magnétique sont connectées à un second conducteur (14) relié à la seconde borne d'entrée (9b) du circuit de traitement (9), le support (11) est constitué par un circuit imprimé, et les premier et second conducteurs (13 et 14) sont constitués respectivement par des première et seconde pistes conductrices du circuit imprimé qui sont routées en zigzag sur le circuit imprimé (11) de manière à former une torsade ou une tresse.

2. Capteur de courant selon la revendication 1, **caractérisé en ce que** le circuit imprimé (11) a deux faces imprimées (11a, 11b) et les pistes conductrices (13, 14) sont routées sur les deux faces (11a et 11b) du circuit imprimé.

3. Capteur de courant selon la revendication 1 ou 2, **caractérisé en ce que** chacune des première et seconde pistes conductrices (13 et 14) forme une boucle fermée tout autour d'une ouverture (12) prévue dans le circuit imprimé (11) pour le passage du conducteur (4) parcouru par le courant à mesurer.

4. Capteur de courant selon l'une quelconque des revendications 1 à 3, **caractérisé en ce que** chaque résistance de sommation (7) a ses deux bornes qui sont connectées respectivement au plus près de la première borne (6a) du composant correspondant (6) sensible au champ magnétique et au plus près de la première piste conductrice (13).

5. Capteur de courant selon l'une quelconque des revendications 1 à 4, **caractérisé en ce que** le circuit imprimé (11) comporte sur au moins une de ses deux faces (11a et 11b) un plan de masse (15a, 15b) entourant étroitement les pistes conductrices (13, 14) du circuit imprimé (11).

6. Capteur de courant selon la revendication 5,
**caractérisé en ce que** le plan de masse (15a, 15b) forme une boucle fermée tout autour de ladite ouverture (12).

7. Capteur de courant selon la revendication 5 ou 6, **caractérisée en ce que** la seconde piste conductrice (14) est reliée au plan de masse (15a, 15b) en un point (16) de celui-ci qui est adjacent à la première piste conductrice (13), et ledit point de sommation (8) auquel est reliée la première piste conductrice (13) est adjacent audit point (16) du plan de masse auquel est reliée la seconde piste conductrice (14).

8. Capteur de courant selon l'une quelconque des revendications 1 à 7, **caractérisé en ce que** les composants (6) sensibles au champ magnétique sont des sondes à effet Hall.

9. Capteur de courant selon la revendication 8, **caractérisé en ce que** chaque sonde (6) à effet Hall comprend des troisième et quatrième bornes (6c, 6d), les troisièmes bornes (6c) de toutes les sondes (6) à effet Hall étant connectées à une troisième piste conductrice (17) du circuit imprimé (11), qui est reliée à un point (18) à un premier potentiel fixe et qui est routée en zigzag sur ledit circuit imprimé de manière à former une torsade ou une tresse avec les première et seconde pistes conductrices (13, 14).

10. Capteur de courant selon la revendication 9, **caractérisé en ce que** la troisième piste conductrice (17) forme une boucle fermée tout autour de ladite ouverture (12).

11. Capteur de courant selon la revendication 9 ou 10, **caractérisé en ce que** les seconde et quatrième bornes (6b, 6d) des sondes (6) à effet Hall sont connectées ensemble à la seconde piste conductrice (14) du circuit imprimé (11), elle-même reliée à un second potentiel fixe ou potentiel de masse (15).

12. Capteur de courant selon la revendication 10 ou 11, **caractérisé en ce que** ledit point (18) au premier potentiel fixe auquel est reliée la troisième piste conductrice (17) est situé sur le circuit imprimé (11) à côté dudit point de sommation (8) et dudit point (16) de connexion au plan de masse (15).

## Claims

1. A current sensor intended to measure the value of the current flowing through a conductor (4), comprising a support (11) capable of being positioned around the conductor through which the current to be measured flows, a plurality of components (6) which are sensitive to the magnetic field, which are arranged on said support (11) so as to be distributed around said conductor (4), and a processing circuit (9) which receives an output signal from said components (6) which are sensitive to the magnetic field, each component which is sensitive to the magnetic field comprising at least a first and a second terminal, the first terminals (6a) of all the components (6) which are sensitive to the magnetic field being connected by respective summation resistors (7) to a summation point (8) connected to a first input terminal (9a) of the processing circuit (9), the second terminals (6b) of all the components (6) which are sensitive to the magnetic field being connected to a second input terminal (9b) of the processing circuit, **characterised in that** all the summation resistors (7) are connected to a first conductor (13) which is connected to the summation point (8), all the second terminals (6b) of the components (6) which are sensitive to the magnetic field are connected to a second conductor (14) which is connected to the second input terminal (9b) of the processing circuit (9), the support (11) is formed by a printed circuit board, and the first and second conductors (13 and 14) are formed respectively by first and second conductive tracks of the printed circuit which are routed in a zigzag on the printed circuit board (11) so as to form a twist or a braid.

2. A current sensor according to Claim 1, **characterised in that** the printed circuit board (11) has two printed faces (11a, 11b) and the conductive tracks (13, 14) are routed on the two faces (11a and 11b) of the printed circuit board.

3. A current sensor according to Claim 1 or 2, **characterised in that** each of the first and second conductive tracks (13 and 14) forms a closed loop all around an opening (12) provided in the printed circuit board (11) for the conductor (4) through which the current to be measured flows to pass through.

4. A current sensor according to any one of Claims 1 to 3, **characterised in that** each summation resistance (7) has its two terminals which are connected respectively as closely as possible to the first terminal (6a) of the corresponding component (6) which is sensitive to the magnetic field and as closely as possible to the first conductive track (13).

5. A current sensor according to any one of Claims 1 to 4, **characterised in that** the printed circuit board (11) comprises on at least one of its two faces (11a and 11b) a ground plane (15a, 15b) closely surrounding the conductive tracks (13, 14) of the printed circuit board (11).

6. A current sensor according to Claim 5, **characterised in that** the ground plane (15a, 15b) forms a closed loop all around said opening (12).

7. A current sensor according to Claim 5 or 6, **characterised in that** the second conductive track (14) is connected to the ground plane (15a, 15b) at a point (16) thereon which is adjacent to the first conductive track (13), and said summation point (8) to which the first conductive track (13) is connected is adjacent to said point (16) of the ground plane to which the second conductive track (14) is connected.

8. A current sensor according to any one of Claims 1 to 7, **characterised in that** the components (6) which are sensitive to the magnetic field are Hall-effect sensors.

9. A current sensor according to Claim 8, **characterised in that** each Hall-effect sensor (6) comprises third and fourth terminals (6c, 6d), the third terminals (6c) of all the Hall-effect sensors (6) being connected to a third conductive track (17) of the printed circuit board (11), which is connected to a point (18) at a first fixed potential and which is routed in a zigzag on said printed circuit board so as to form a twist or a braid with the first and second conductive tracks (13, 14).

10. A current sensor according to Claim 9, **characterised in that** the third conductive track (17) forms a closed loop all around said opening (12).

11. A current sensor according to Claim 9 or 10, **characterised in that** the second and fourth terminals (6b, 6d) of the Hall-effect sensors (6) are connected together to the second conductive track (14) of the printed circuit board (11), which track itself is connected to a second fixed potential or earth potential (15).

12. A current sensor according to Claim 10 or 11, **characterised in that** said point (18) at the first fixed potential to which the third conductive track (17) is connected is located on the printed circuit board (11) next to said summation point (8) and said point (16) of connection to the ground plane (15).

## Patentansprüche

1. Stromsensor zur Messung der Größe eines in einem Leiter (4) fließenden Stroms, mit einem Träger (11), der um den vom Strom durchflossenen Leiter herum positionierbar ist, mehreren magnetfeldempfindlichen Komponenten (6), die auf dem Träger (11) derart angeordnet sind, dass sie um den Leiter (4) herum verteilt sind, und eine Verarbeitungsschaltung (9), die ein Ausgangssignal der magnetfeldempfindlichen Komponenten (6) empfängt, wobei jede magnetfeldempfindliche Komponente mindestens einen ersten und zweiten Anschluss aufweist, wobei die ersten Anschlüsse (6a) aller magnetfeldempfindlichen Komponenten (6) über jeweilige Summierwiderstände (7) an einen Summierpunkt (8) angeschlossen sind, der mit einer ersten Eingangsklemme (9a) der Verarbeitungsschaltung (9) verbunden ist, und wobei die zweiten Anschlüsse (6b) aller magnetfeldempfindlichen Komponenten (6) mit einer zweiten Eingangsklemme (9b) der Verarbeitungsschaltung verbunden sind, **dadurch gekennzeichnet, dass** alle Summierwiderstände (7) mit einem ersten Leiter (13) verbunden sind, der mit dem Summierpunkt (8) verbunden ist, dass alle zweiten Anschlüsse (6b) der magnetfeldempfindlichen Komponenten (6) mit einem zweiten Leiter (14) verbunden sind, der mit der zweiten Eingangsklemme (9b) der Verarbeitungsschaltung (9) verbunden ist, dass der Träger (11) aus einer gedruckten Schaltung besteht, und dass der erste und zweite Leiter (13, 14) von einer ersten bzw. zweiten Leiterbahn der gedruckten Schaltung gebildet werden, die derart zickzackförmig auf der gedruckten Schaltung (11) angeordnet sind, dass sie eine Litze oder ein Geflecht bilden.

2. Stromsensor nach Anspruch 1, **dadurch gekennzeichnet, dass** die gedruckte Schaltung (11) zwei gedruckte Flächen (11a, 11b) aufweist und die Leiterbahnen (13, 14) auf beiden Flächen (11a, 11b) der gedruckten Schaltung verlaufen.

3. Stromsensor nach Anspruch 1 oder 2, **dadurch gekennzeichnet, dass** jede erste und zweite Leiterbahn (13, 14) eine geschlossene Schleife um eine Öffnung (12) herum bildet, die in der gedruckten Schaltung (11) für den Durchtritt des von dem zu messenden Strom durchflossenen Leiters (4) vorgesehen ist.

4. Stromsensor nach einem der Ansprüche 1 bis 3, **dadurch gekennzeichnet, dass** jeder Summierwiderstand (7) seine zwei Anschlüsse aufweist, die mit dem nächstgelegenen ersten Anschluss (6a) der entsprechenden magnetfeldempfindlichen Komponente (6) bzw. mit der nächstgelegenen Stelle der ersten Leiterbahn (13) verbunden sind.

5. Stromsensor nach einem der Ansprüche 1 bis 4, **dadurch gekennzeichnet, dass** die gedruckte Schaltung (11) auf mindestens einer ihrer beiden Flächen (11a, 11b) eine Massefläche trägt, die eng von den Leiterbahnen (13, 14) der gedruckten Schaltung (11) umgeben ist.

6. Stromsensor nach Anspruch 5, **dadurch gekennzeichnet, dass** die Massefläche (15a, 15b) eine geschlossene Schleife um die Öffnung (12) herum bildet.

7. Stromsensor nach Anspruch 5 oder 6, **dadurch gekennzeichnet, dass** die zweite Leiterbahn (14) mit der Massefläche (15a, 15b) an einem Punkt (16) derselben verbunden ist, der an die erste Leiterbahn (13) angrenzt, und dass der Summierpunkt (8), mit dem die erste Leiterbahn (13) verbunden ist, angrenzend an den Punkt (16) der Massefläche liegt, mit dem die zweite Leiterbahn (14) verbunden ist.

8. Stromsensor nach einem der Ansprüche 1 bis 7, **dadurch gekennzeichnet, dass** die magnetfeldempfindlichen Komponenten (6) Hall-Effekt-Sonden sind.

9. Stromsensor nach Anspruch 8, **dadurch gekennzeichnet, dass** jede Hall-Effekt-Sonde einen dritten und vierten Anschluss (6c, 6d) aufweist, wobei die dritten Anschlüsse (6c) aller Hall-Effekt-Sonden mit einer dritten Leiterbahn (17) der gedruckten Schaltung (11) verbunden sind, die an einem Punkt (18) an ein erstes Festpotential angeschlossen ist und die derart zickzackförmig auf der gedruckten Schaltung verläuft, dass sie mit der ersten und zweiten Leiterbahn (13, 14) eine Litze oder ein Geflecht bildet.

10. Stromsensor nach Anspruch 9, **dadurch gekennzeichnet, dass** die dritte Leiterbahn (17) eine geschlossene Schleife um die Öffnung (12) herum bildet.

11. Stromsensor nach Anspruch 9 oder 10, **dadurch gekennzeichnet, dass** der zweite und vierte Anschluss (6b, 6d) der Hall-Effekt-Sonden (6) gemeinsam mit der zweiten Leiterbahn (14) der gedruckten Schaltung (11) verbunden sind, die ihrerseits an ein Festpotential oder ein Massepotential (15) angeschlossen sind.

12. Stromsensor nach Anspruch 10 oder 11, **dadurch gekennzeichnet, dass** der Punkt (18) mit dem ersten Festpotential, mit dem die Leiterbahn (17) verbunden ist, auf der gedruckten Schaltung (11) neben dem Summierpunkt (8) und dem mit der Massefläche (15) verbunden Punkt (16) angeordnet ist.
